(19) Europäisches Patentamt
European Patent Office
Office européen des brevets

(11) EP 4 808 328 A1

(12) **EUROPEAN PATENT APPLICATION**
published in accordance with Art. 153(4) EPC

(43) Date of publication:
**16.09.2026 Bulletin 2026/38**

(21) Application number: **24913360.4**

(22) Date of filing: **21.11.2024**

(51) International Patent Classification (IPC):
***H10K 59/80*** (2023.01) ***B29C 39/14*** (2006.01)
***B29C 39/38*** (2006.01) ***B29C 39/00*** (2006.01)
***B29C 70/06*** (2006.01) ***C08J 5/18*** (2006.01)
***C08K 5/12*** (2006.01) ***C08K 7/02*** (2006.01)
***C08K 3/22*** (2006.01)

(52) Cooperative Patent Classification (CPC):
**B29C 39/00; B29C 39/14; B29C 39/38; B29C 70/06; C08J 5/18; C08K 3/22; C08K 5/12; C08K 7/02; H10K 59/80**

(86) International application number:
**PCT/KR2024/018466**

(87) International publication number:
**WO 2025/143553 (03.07.2025 Gazette 2025/27)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **28.12.2023 KR 20230194263**

(71) Applicant: **Kolon Industries, Inc.**
**Seoul 07793 (KR)**

(72) Inventors:
- **KWON, Kyung Wook**
  **Seoul 07793 (KR)**
- **SHIN, In Ho**
  **Seoul 07793 (KR)**

(74) Representative: **Ter Meer Steinmeister & Partner Patentanwälte mbB**
**Nymphenburger Straße 4**
**80335 München (DE)**

# (54) OPTICAL FILM HAVING EXCELLENT TEARING STRENGTH AND DISPLAY DEVICE COMPRISING SAME

(57) One embodiment of the present invention provides an optical film and a display device comprising same, the optical film comprising a light-transmitting matrix, and a filler dispersed in the light-transmitting matrix, wherein the filler has a fiber shape, and when the filler has diameter A and length B, the ratio B/A is 10 to 500 and the tearing index is in the range of 1.10 to 1.50.

FIG. 1

100
110
120
S2
S1



Processed by Luminess, 75001 PARIS (FR)

## Description

[Technical Field]

The present disclosure relates to an optical film and a display device including the same and more particularly, to an optical film having excellent tearing strength.

[Background Art]

Recently, the use of an optical film instead of glass as a cover window of a display device has been considered with the goal of reducing thickness and weight and increasing the flexibility of the display device. In order for the optical film to be usable as a cover window of a display device, the optical film needs to have superior optical properties and excellent mechanical properties. For example, an optical film needs to have properties such as excellent strength, hardness, abrasion resistance, and flexibility.

Fillers may be added in order to impart desired physical properties to an optical film requiring various physical properties. The fillers may vary depending on physical properties required for the optical film.

[Disclosure]

[Technical Problem]

Therefore, the present disclosure has been made in view of the above problems, and it is one aspect of the present disclosure to provide an optical film that includes a fiber- or filament-shaped filler dispersed in a light-transmitting matrix.

It is another aspect of the present disclosure to provide an optical film that includes a fiber- or filament-shaped filler, which is dispersed in a light-transmitting matrix and links polymer chains constituting the light-transmitting matrix to improve the stability and arrangement characteristics of the polymer chains.

It is another aspect of the present disclosure to provide an optical film that includes a fiber- or filament-shaped filler dispersed in a light-transmitting matrix and thus has excellent tearing strength.

It is yet another aspect of the present disclosure to provide a display device including the optical film.

[Technical Solution]

In accordance with an aspect of the present disclosure, the above and other objects can be accomplished by the provision of an optical film including a light-transmitting matrix and a filler dispersed in the light-transmitting matrix, wherein the filler has a fiber shape, the filler has B/A of 10 to 500, wherein A represents a diameter of the filler and B represents a length of the filler, and the optical film has a tearing index of 1.10 to 1.50,

wherein the tearing index is calculated in accordance with the following Equation 1:

Tearing Index = TD tearing strength / MD tearing strength [Equation 1]

wherein the machine direction (MD) is a direction parallel to a casting direction of the optical film during a manufacturing process of the optical film and the transverse direction (TD) is a direction perpendicular to the machine direction (MD).

In an embodiment of the present disclosure, the optical film may have B/A of 200 to 400.

In an embodiment of the present disclosure, the filler may have a diameter of 2 nm to 10 nm and a length of 200 nm to 4,000 nm.

In an embodiment of the present disclosure, the filler may include at least one of glass fiber, an aluminum-based fiber, or fluoride fiber.

In an embodiment of the present disclosure, the filler may include aluminum oxide hydroxide.

In an embodiment of the present disclosure, a content of the filler may be 1 to 40 wt% based on a total weight of the optical film.

In an embodiment of the present disclosure, the optical film may have a TD tearing strength of 2.0 N/mm or more.

In an embodiment of the present disclosure, the optical film may have a modulus of 7 GPa or more based on a thickness of 50 μm.

In an embodiment of the present disclosure, the filler may have a MD orientation degree of 60% to 90%,

wherein the MD is a casting direction of the optical film during a manufacturing process of the optical film, and the MD orientation degree is measured under the following conditions using a FT-IR spectrometer,

- FT-IR spectrometer: PerkinElmer spectrum 100
- Veemax III with ATR and 45-degree ZnSe crystal
- Incident angle of 80 degrees (air to crystal), polarization angle of 0 degrees

In an embodiment of the present disclosure, the optical film may have a surface hardness of 2H or higher based on a thickness of 50 μm.

In an embodiment of the present disclosure, the optical film may have a yellowness index of 3 or less based on a thickness of 50 μm.

In accordance with another aspect of the present disclosure, there is provided a display device including a display panel and the optical film disposed on the display panel.

In accordance with yet another aspect of the present disclosure, there is provided a method of manufacturing an optical film including primarily dispersing a filler in a resin solution for forming a polymer matrix to prepare a first mixed solution, adjusting a pH of the first mixed solution to 5 to 7 to improve arrangement characteristics of the filler in the first mixed solution, casting the first mixed solution to prepare a cast film, applying a coating pressure of 10 to 30 kPa to the cast film, and drying the cast film while heating at a heating rate of 1°C/1 minute from 80°C to 120°C, wherein the filler has a fiber shape, and the filler has B/A of 10 to 500, wherein A represents a diameter of the filler and B represents a length of the filler.

[Advantageous Effects]

According to one embodiment of the present disclosure, the filler included in the optical film has a fiber or filament shape and can link (entangle) the polymer chains constituting the light-transmitting matrix. As a result, the mechanical strength of the optical film may be improved and in particular, the tearing strength of the optical film may be improved.

According to one embodiment of the present disclosure, the filler included in the optical film has an MD orientation degree of 60% to 90%, thereby improving the TD tearing strength of the optical film.

The optical film according to one embodiment of the present disclosure includes a fiber- or filament-shaped filler, thereby exhibiting excellent optical properties and mechanical properties.

The optical film according to one embodiment of the present disclosure may have excellent optical properties and mechanical properties and thus may be useful as a cover window of a display device.

[Description of Drawings]

FIG. 1 is a schematic diagram illustrating an optical film according to an embodiment of the present disclosure.
FIG. 2 is a cross-sectional view illustrating a part of a display device according to another embodiment of the present disclosure.
FIG. 3 is an enlarged cross-sectional view illustrating part "P" in FIG. 2.
FIG. 4 is an example of an FT-IR graph of an optical film according to one embodiment of the present disclosure.

[Best Mode]

Hereinafter, embodiments of the present disclosure will be described in detail with reference to the accompanying drawings. However, the following embodiments are illustratively provided merely for clear understanding of the present disclosure and do not limit the scope of the present disclosure.

The shapes, sizes, ratios, angles, and numbers disclosed in the drawings for describing embodiments of the present disclosure are merely examples, and the present disclosure is not limited to the illustrated details. Like reference numerals refer to like elements throughout the present specification. In the following description, when a detailed description of relevant known functions or configurations is determined to unnecessarily obscure important points of the present disclosure, the detailed description will be omitted.

In the case in which a term such as "comprise", "have", or "include" is used in the present specification, another part may also be present, unless "only" is also used. Terms in a singular form may include the plural meanings, unless noted to the contrary. Also, in construing an element, the element is to be construed as including an error range, although there is no explicit description thereof.

In describing a positional relationship, for example, when the positional relationship is described using "on", "above", "below", or "next to", the case of no contact therebetween may be included, unless "immediately" or "directly" is used.

Spatially relative terms, such as "below", "beneath", "lower", "above", and "upper", may be used herein to describe the relationship between a device or element and another device or element, as shown in the figures. It will be understood that spatially relative terms are intended to encompass different orientations of a device during the use or operation of the device, in addition to the orientation depicted in the figures. For example, if a device in one of the figures is turned upside down, elements described as "below" or "beneath" other elements would then be positioned "above" the other elements. The exemplary term "below" or "beneath" can, therefore, encompass the meanings of both "below" and "above". In the same manner, the exemplary term "above" or "upper" can encompass the meanings of both "above" and "below".

In describing temporal relationships, for example, when a temporal order is described using "after", "subsequent", "next", or "before", the case of a non-continuous relationship may be included, unless "immediately" or "directly" is used.

It will be understood that, although the terms "first", "second", etc. may be used herein to describe various elements, these elements are not limited by these terms. These terms are only used to distinguish one element from another. Therefore, a first element could be termed a second element within the technical idea of the present disclosure.

It should be understood that the term "at least one" includes all combinations related with one or more items. For example, "at least one among a first element, a second element, and a third element" may include all combinations of two or more elements selected from among the first, second, and third elements, as well as each of the first, second, and third elements.

Features of various embodiments of the present disclosure may be partially or completely integrated or combined with each other, and may be variously interoperated with each other and driven technically. The embodiments of the present disclosure may be carried out independently from each other, or may be carried out together in an interrelated manner.

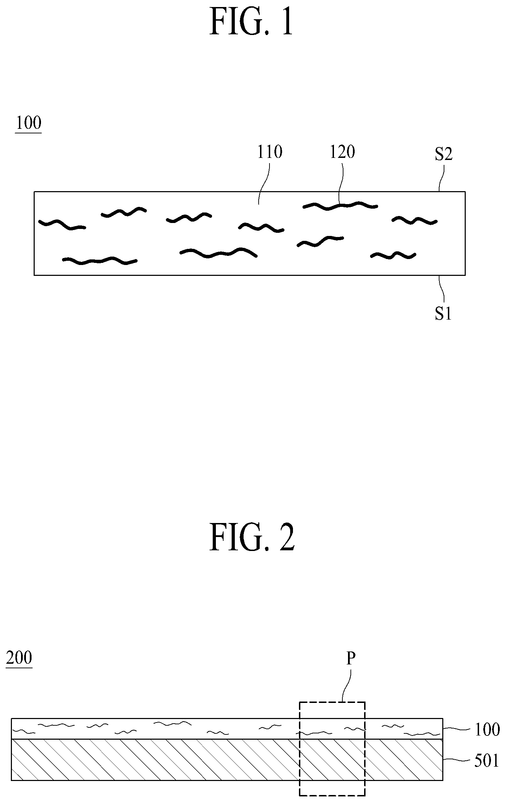

FIG. 1 is a schematic diagram illustrating an optical film 100 according to an embodiment of the present disclosure. According to one embodiment of the present disclosure, a film having light transmittance is referred to as an "optical film 100".

According to one embodiment of the present disclosure, the optical film 100 may have a first surface S1 and a second surface S2 that face each other.

For example, when the optical film 100 is manufactured by casting, the surface of the optical film 100 that contacts the casting substrate may be referred to as a "belt surface". According to one embodiment of the present disclosure, the belt surface of the optical film 100 is referred to as the "first surface S1". In addition, the optical film 100 may have a surface that faces the belt surface, and the surface that faces the belt surface may be referred to as an "air surface". According to one embodiment of the present disclosure, the air surface of the optical film 100 is referred to as the "second surface S2".

The optical film 100 according to an embodiment of the present disclosure includes a light-transmitting matrix 110 and a filler 120 dispersed in the light-transmitting matrix 110.

The light-transmitting matrix 110 may be light-transmitting. According to an embodiment of the present disclosure, the light-transmitting matrix 110 may be flexible. For example, the optical film according to an embodiment of the present disclosure may be bendable, foldable, or rollable. As a result, the optical film 100 according to an embodiment of the present disclosure may be light-transmitting and may be bendable, foldable, or rollable.

According to an embodiment of the present disclosure, the light-transmitting matrix 110 may include at least one of an imide repeating unit or an amide repeating unit.

The light-transmitting matrix 110 according to an embodiment of the present disclosure may be produced from monomer ingredients including diamine and dianhydride. Specifically, the light-transmitting matrix 110 may include an imide repeating unit formed by the dianhydride and the diamine. The light-transmitting matrix 110 having an imide repeating unit may, for example, be a polyimide resin.

However, the light-transmitting matrix 110 according to an embodiment of the present disclosure is not limited thereto and the light-transmitting matrix 110 may be produced from ingredients including a dicarbonyl-based compound and a diamine-based monomer. Specifically, the light-transmitting matrix 110 may include an amide repeating unit formed by a dicarbonyl-based compound and a diamine-based monomer. The light-transmitting matrix 110 having an imide repeating unit may, for example, be a polyamide resin.

In addition, the light-transmitting matrix 110 according to an embodiment of the present disclosure may be produced from monomer ingredients including a dicarbonyl-based compound in addition to the dianhydride and the diamine. Specifically, the light-transmitting matrix 110 may have an imide repeating unit and an amide repeating unit. For example, the light-transmitting matrix 110 having an imide repeating unit and an amide repeating unit may be a polyamide-imide resin.

According to one embodiment of the present disclosure, the light-transmitting matrix 110 may include a polyimide-based polymer. Examples of the polyimide-based polymer may include polyimide polymers, polyamide-imide

polymers and the like. The light-transmitting matrix 110 according to an embodiment of the present disclosure may be produced from, for example, a polyimide-based polymer resin.

According to one embodiment of the present disclosure, the light-transmitting matrix 110 may be formed from a polymerizable composition containing a diamine-based monomer, and at least one of a dianhydride-based compound or a dicarbonyl-based compound.

The polymerizable composition according to an embodiment of the present disclosure may include a diamine-based monomer.

According to an embodiment of the present disclosure, for example, the diamine-based compound may include at least one of m-tolidine, 2,2'-bis(trifluoromethyl)benzidine (TFDB), 4,4'-oxydianiline (ODA), p-phenylenediamine (pPDA), m-phenylenediamine (mPDA), p-methylenediamine (pMDA), m-methylenediamine (mMDA), 1,3-bis(3-aminophenoxy)benzene (133APB), 1,3-bis(4-aminophenoxy)benzene (134APB), 2,2'-bis[4(4-aminophenoxy)phenyl] hexafluoropropane (4BDAF), 2,2'-bis(3-aminophenyl) hexafluoropropane (33-6F), 2,2'-bis(4-aminophenyl) hexafluoropropane (44-6F), bis(4-aminophenyl)sulfone (4DDS), bis(3-aminophenyl)sulfone (3DDS), 1,3-cyclohexanediamine (13CHD), 1,4-cyclohexanediamine (14CHD), 2,2-bis(4-(4-aminophenoxy)phenyl)propane (6HMDA), 2,2-bis(3-amino-4-hydroxyphenyl)hexafluoropropane (DBOH), or 4,4'-bis(3-aminophenoxy)diphenylsulfone (DBSDA).

More specifically, according to an embodiment of the present disclosure, for example, the diamine-based compound may include at least one of m-tolidine, 2,2'-bis(trifluoromethyl)benzidine (TFDB), para-phenylene diamine (pPDA), meta-phenylene diamine (mPDA), para-methylene diamine (pMDA), meta-methylene diamine (mMDA), bis(4-aminophenyl)sulfone (4DDS), bis(3-aminophenyl)sulfone (3DDS), or 4,4'-bis(3-aminophenoxy)diphenylsulfone (DBSDA), but one embodiment of the present disclosure is not limited thereto.

The polymerizable composition according to an embodiment of the present disclosure may include at least one of a dianhydride-based compound or a dicarbonyl-based compound.

According to one embodiment of the present disclosure, the dianhydride-based compound may, for example, include at least one of 4,4'-(4,4-isopropylidenediphenoxy)bis(phthalic anhydride (4IBA), 3,3,4,4-biphenyltetracarboxylic dianhydride (BPDA), 2,2-bis(3,4-dicarboxyphenyl)hexafluoropropane dianhydride (6FDA), cyclobutane-1,2,3,4-tetracarboxylic dianhydride (CBDA), 4-(2,5-dioxotetrahydrofuran-3-yl)-1,2,3,4-tetrahydronaphthalene-1,2-dicarboxylic anhydride (TDA), pyromellitic acid dianhydride (1,2,4,5-benzene tetracarboxylic dianhydride, PMDA), 3,3,4,4-benzophenone tetracarboxylic dianhydride (BTDA), 4,4-oxydiphthalic dianhydride (ODPA), bis(3,4-dicarboxyphenyl)dimethyl-silane dianhydride (SiDA), bis(3,4-dicarboxyphenoxy)diphenyl sulfide dianhydride (BDSDA), or sulfonyldiphthalic anhydride (SO2DPA).

More specifically, according to one embodiment of the present disclosure, the dianhydride-based compound may, for example, include at least one of isopropylidenediphenoxy bisphthalic anhydride (4,4'-(4,4'-isopropylidenediphenoxy)bis(phthalic anhydride, 4IBA), 3,3,4,4-biphenyltetracarboxylic dianhydride (BPDA), 2,2-bis(3,4-dicarboxyphenyl)hexafluoropropane dianhydride (6FDA), cyclobutane-1,2,3,4-tetracarboxylic dianhydride (CBDA), pyromellitic acid dianhydride (1,2,4,5-benzene tetracarboxylic dianhydride, PMDA), 3,3,4,4-benzophenone tetracarboxylic dianhydride (BTDA), or 4,4-oxydiphthalic dianhydride (ODPA), but one embodiment of the present disclosure is not limited thereto.

According to one embodiment of the present disclosure, the dicarbonyl-based compound may, for example, include at least one of terephthaloyl chloride (TPC), phthaloyl chloride, isophthaloyl chloride (IPC), 4,4'-biphenyldicarbonyl chloride (DPDOC), 4,4'-oxybis(benzoyl chloride) (OBBOC), naphthalene-2,3-dicarbonyl dichloride, or 1,4-cyclohexanedicabonyldichloride (CHDOC).

More specifically, according to one embodiment of the present disclosure, the dicarbonyl-based compound may, for example, include at least one of terephthaloyl chloride (TPC), phthaloyl chloride, or isophthaloyl chloride, but one embodiment of the present disclosure is not limited thereto. According to one embodiment of the present disclosure, the total equivalent weight of the dianhydride-based compound and the dicarbonyl-based compound may be substantially the same as the equivalent weight of the diamine-based monomer.

According to an embodiment of the present disclosure, the light-transmitting matrix 110 may have a thickness sufficient for the optical film 100 to protect the display panel. For example, the light-transmitting matrix 110 may have a thickness of 10 to 100 μm. The thickness of the light-transmitting matrix 110 may be the same as that of the optical film 100.

The filler 120 may have a fiber shape. The fiber may mean, for example, a material, the length of which is significantly longer than a diameter thereof. The fiber may mean a material that is long and thin like a thread. The fiber may mean a material that has a linear structure. The fiber may also mean a material that is long and bendable.

Hereinafter, a shape having a length greater than a diameter is referred to as a "fiber shape". The fiber shape may also be referred to as a "filament shape". According to one embodiment of the present disclosure, the length of the filler 120 may be more than twice the diameter thereof.

According to one embodiment of the present disclosure, the filler 120 has a fiber shape and thus can link the polymer chains constituting the light-transmitting matrix 110. As a result, the stability and arrangement characteristics of the polymer chains can be improved, the mechanical properties of the light-transmitting matrix 110 can be improved, and the mechanical properties of the optical film 100 can also be improved.

According to one embodiment of the present disclosure, the filler 120 may have B/A of 10 to 500 wherein A represents a diameter of the filler 120 and B represents a length of the filler 120.

When the ratio of the length to the diameter of the filler 120 (B/A) is less than 10, the function of the filler 120 to link the polymer chains may not be sufficiently exerted due to insufficient length of the filler 120, and the interaction between the polymer chains and the filler 120 may be reduced and thus the effect of improving the tearing strength may not be sufficiently achieved.

When the ratio of the length to the diameter of the filler 120 (B/A) is greater than 500, the filler 120 may reduce the dispersibility of the filler 120 and cause agglomeration of the filler 120 within the light-transmitting matrix 110 due to excessively great length. As a result, the optical film 100 may have decreased light transmittance, increased haze and deteriorated optical properties. In addition, the mechanical strength of the optical film 100 may decrease in the area where agglomeration of the filler 120 occurs.

According to one embodiment of the present disclosure, the ratio of the length to the diameter of the filler 120 (B/A) is for example, in the range of 50 to 400. More specifically, the ratio of the length to the diameter of the filler 120 (B/A) may be in the range of, for example, 50 to 500, in the range of 100 to 500, in the range of 100 to 400, or in the range of 200 to 400. The ratio of the length to the diameter of the filler 120 (B/A) may be in the range of 300 to 400.

According to one embodiment of the present disclosure, when the ratio of the length to the diameter of the filler 120 is 50 or more, and the long filler 120 is aligned in one direction, the resistance to force in the direction perpendicular to the alignment direction increases and thus the tearing strength of the optical film 100 may be further improved. Meanwhile, when the ratio of the length to the diameter of the filler 120 is 400 or less, the tearing strength of the optical film 100 may be improved while a decrease in folding performance may be prevented.

According to one embodiment of the present disclosure, the filler 120 may have a diameter of 2 nm to 10 nm and a length of 200 nm to 4,000 nm.

According to one embodiment of the present disclosure, the diameter and length of the filler 120 may be measured with a transmission electron microscope (TEM).

When the diameter of the filler 120 is less than 2 nm, the filler 120 may have a decreased stability and may be cut or broken, thus causing contamination of the optical film 100 and increasing the haze of the optical film 100. When the diameter of the filler 120 is higher than 10 nm, the filler 120 has difficulty in having a fiber shape, the function of the filler 120 to link the polymer chains may be deteriorated, and the optical film 100 may have decreased light transmittance.

When the length of the filler 120 is less than 200 nm, the function of the filler 120 to link the polymer chains may not be sufficiently exerted. When the length of the filler 120 is higher than 4,000 nm, the dispersibility of the filler 120 may decrease, and as a result, agglomeration of the filler 120 may occur within the light-transmitting matrix 110. As a result, the optical film 100 may have decreased light transmittance, increased haze and deteriorated optical properties.

There is no particular limitation on the type of filler 120. Any filler may be used without limitation as the filler 120 according to an embodiment of the present disclosure so long as it has a fiber shape. The filler 120 may be inorganic or organic. The filler 120 may include at least one of inorganic fibers, organic fibers, or organic-inorganic hybrid fibers.

More specifically, the filler 120 may have a fiber shape. For example, the filler 120 may have a single-stranded fiber shape, a multi-stranded fiber shape, or a branch shape in which multiple strands are arranged in the form of branches based on one central strand.

According to one embodiment of the present disclosure, the filler 120 may include at least one of glass fiber, an aluminum-based fiber, or fluoride fiber.

The glass fiber may contain $SiO_2$ and may further contain other components in addition to $SiO_2$. The aluminum-based fiber contains aluminum oxide hydroxide. The aluminum-based fiber may further contain other components in addition to aluminum oxide hydroxide. The fluoride fiber may contain at least one of polytetrafluoroethylene (PTFE) or polyvinylidene fluoride (PVDF) and may further contain other components in addition to PTFE and PVDF.

More specifically, the filler 120 may include at least one of aluminum oxide hydroxide, $SiO_2$, PTFE (polytetrafluoroethylene), or polyvinylidene fluoride (PVDF).

According to one embodiment of the present disclosure, the filler 120 may include an aluminum-based fiber. The aluminum-based fiber may include aluminum oxide hydroxide.

According to one embodiment of the present disclosure, the filler 120 may include aluminum oxide hydroxide. Aluminum oxide hydroxide is also called "Boehmite" and may be represented by $\gamma$-AlO(OH). More specifically, aluminum oxide hydroxide may include a structure represented by any of the following Formulas 1, 2, and 3.

[Formula 1]

OH
O
Al
O
O
Al
O
OH
n

[Formula 2]

[Formula 3]

H
O
O
Al
Al
O
O
H
p

wherein n ranges from 50 to 10,000, m ranges from 50 to 10,000, and p ranges from 100 to 20,000.

When the structures of Formulas 1, 2 and 3 are expanded for better understanding of the structure of the filler 120, the filler 120 may be represented by any one of Formulas 4, 5 and 6.

The structure represented by Formula 1 may be represented by, for example, Formula 4 below. Formula 4 below corresponds to the structure of Formula 1 wherein n is 5.

[Formula 4]

The structure represented by Formula 2 may be represented by, for example, Formula 5 below. Formula 5 below corresponds to the structure of Formula 2 wherein m is 4.

[Formula 5]

The structure represented by Formula 3 may be represented by, for example, Formula 6 below. Formula 6 below corresponds to the structure of Formula 3 wherein p is 3.

[Formula 6]

In Formulas 4 to 6, "*" represents a binding position.

According to one embodiment of the present disclosure, the filler 120 may be surface-treated. For example, the filler 120 may be surface-treated with an organic compound group having an alkoxy group.

According to an embodiment of the present disclosure, the filler 120 may cause appropriate light scattering to improve the optical properties of the optical film 100. To enhance the light scattering effect, the content of the filler 120 in the optical film 100 may be adjusted.

According to one embodiment of the present disclosure, the content of the filler 120 may be 1 to 40 wt%, based on the total weight of the optical film 100.

According to one embodiment of the present disclosure, when the filler 120 is dispersed within the light-transmitting matrix 110, the tearing strength of the optical film 100 may be increased due to the high strength of the filler 120 itself. In addition, the filler 120 may, for example, link the polymer chains constituting the light-transmitting matrix 110, like reinforced concrete, thus making the overall polymer resin structure strong.

When the content of the filler 120 is less than 1 wt%, based on the total weight of the optical film 100, the effect of

improving the light transmittance of the optical film 10 cannot be obtained because the light scattering effect by the filler 120 is insufficient, and the optical film 100 cannot sufficiently exert the effect of improving mechanical properties such as tearing strength because the function of the filler 120 to link the polymer chains is not sufficiently exerted.

On the other hand, when the content of the filler 120 is higher than 40 wt%, based on the total weight of the optical film 100, the dispersibility of the filler 120 may decrease, the haze of the optical film 100 may decrease, agglomeration of the filler 120 may occur due to the excessive amount of the filler 120, and the agglomerated filler 120 blocks light, which may reduce the light transmittance of the optical film 100.

More specifically, the content of the filler 120 with respect to the total weight of the optical film 100 may be adjusted to 3 to 40 wt%, may be adjusted to 5 to 40 wt%, may be adjusted to 5 to 30 wt%, and may also be adjusted to 5 to 20 wt%.

According to one embodiment of the present disclosure, by adjusting the diameter, length, and content of the filler 120 and improving the dispersion method, the tearing strength and mechanical strength of the optical film 100 may be improved while an increase in haze and a decrease in light transmittance of the optical film 100 may be prevented.

According to one embodiment of the present disclosure, the optical film 100 may have an MD (machine direction) and a TD (transverse direction).

The direction in which mechanical treatment is applied to the film is referred to as "machine direction (MD)" and the direction perpendicular to the machine direction (MD) is referred to as "transverse direction (TD)". For example, when tension is applied to the film, the direction parallel to the tension direction may be the machine direction (MD), and when the film is cast, the direction parallel to the casting direction may be the machine direction (MD), and when the film is wound through a roller, the direction parallel to the winding direction may be the machine direction (MD).

According to one embodiment of the present disclosure, the machine direction MD is a direction parallel to the casting direction of the optical film 100 during the manufacturing process of the optical film. The MD may be referred to as a "length direction". The transverse direction (TD) is a direction perpendicular to the MD. The transverse direction (TD) may be referred to as a "width direction".

According to one embodiment of the present disclosure, the optical film 100 may have a tearing index in the range of 1.10 to 1.50.

The tearing index is a ratio of a TD tearing strength to an MD tearing strength. The tearing index is calculated in accordance with the following Equation 1.

Tearing Index = TD tearing strength / MD tearing strength [Equation 1]

wherein the machine direction (MD) is a direction parallel to a casting direction of the optical film 100 during the manufacturing process of the optical film 100 and the transverse direction (TD) is a direction perpendicular to the machine direction (MD). More specifically, when the casting direction of the optical film 100 during the process of manufacturing the optical film 100 is 90° and the direction perpendicular to the casting direction is 0°, the filler 120 is defined as being oriented in the MD when it is oriented in a direction of 45° or more (45° to 90°). In addition, when the filler 120 is oriented in a direction less than 45° (0° to 44°), it is defined as being oriented in the TD.

According to one embodiment of the present disclosure, the filler 120 may have a fiber shape and may be dispersed while oriented in a predetermined direction within the light-transmitting matrix 110. More specifically, the filler 120 may be oriented in the machine direction MD or the transverse direction TD. For example, when the orientation direction of the filler 120 is the transverse direction TD, the fiber-shaped filler 120 may be arranged long in the transverse direction TD within the light-transmitting matrix 110. In addition, when the orientation direction of the filler 120 is the machine direction MD, the fiber-shaped filler 120 may be arranged long in the machine direction MD within the light-transmitting matrix 110.

When a fiber-shaped filler 120 is included in the light-transmitting matrix 110, the tearing strength of the optical film 100 may be improved. More specifically, the optical film 100 including the filler 120 arranged in the TD perpendicular to the MD may have increased resistance to tearing in the MD and thus may have a higher MD tearing strength than the TD tearing strength. In addition, the optical film 100 including the filler 120 arranged along the MD perpendicular to the TD may exhibit increased resistance to tearing in the TD and thus may have a higher TD tearing strength than the MD tearing strength.

In an embodiment of the present disclosure, the MD tearing strength and the TD tearing strength of each optical film in Equation 1 may be measured using a universal tensile tester (Model 5967) from Instron in accordance with ASTM D1004 under the following conditions.

According to one embodiment of the present disclosure, the optical film 100 may have a tearing index in the range of 1.10 to 1.50 because it, for example, includes a filler 120 oriented in the TD perpendicular to the MD.

When the tearing index is less than 1.10, the effect of improving TD tearing strength may be insufficient. When the tearing index is more than 1.50, the filler 120 may be oriented excessively in one direction and thus may deteriorate the folding performance of the optical film 100.

According to one embodiment of the present disclosure, the optical film 100 may have a tearing index in the range

of 1.10 to 1.50, and thus may have excellent resistance to tearing in the TD, while having excellent TD folding characteristics. In addition, the optical film 100 may have a tearing index in the range of 1.10 to 1.50 and thus may be used, for example, as a cover window of a display device.

The optical film 100 according to one embodiment of the present disclosure may have a TD tearing strength of 2.0 N/mm or more.

According to one embodiment of the present disclosure, the optical film 100 including the filler 120 oriented in the MD perpendicular to the TD may have an excellent TD tearing strength of 2.0 N/mm or more due to increased resistance to tearing in the TD.

When the TD tearing strength of the optical film 100 is less than 2.0 N/mm, it becomes vulnerable to external impact and the optical film 100 may be easily torn by the external impact.

The optical film 100 according to one embodiment of the present disclosure may have a modulus of 7 GPa or more. More specifically, the optical film 100 according to one embodiment of the present disclosure may have a modulus of 7 GPa or more, may have a modulus of 8 GPa or more, or may have a modulus of 9 GPa or more based on a sample with a size of 10 cm x 1 cm.

According to one embodiment of the present disclosure, the filler 120 may have a fiber shape and thus may link the polymer chains constituting the light-transmitting matrix 110. As a result, the stability and arrangement characteristics of the polymer chains are improved and the intermolecular force increases. Therefore, the optical film 100 may have a high modulus of 7 GPa or more, 8 GPa or more, or 9 GPa or more.

In general, it is known that it is difficult for a film formed of a polymer resin to have a modulus of 6.0 GPa or more. However, according to one embodiment of the present disclosure, by using the fiber-shaped filler 120 and adjusting the diameter, length, the diameter-to-length ratio (B/A) and the content ratio of the filler 120 dispersed in the light-transmitting matrix 110, a large modulus of 7 GPa or more may be imparted to the optical film 100.

According to one embodiment of the present disclosure, the filler 120 may have an MD orientation degree of 60% to 90%.

The MD orientation degree of the filler 120 is a parameter indicating a degree to which the filler 120 is oriented in the MD. According to one embodiment of the present disclosure, the MD orientation degree of the filler 120 is determined by light absorption depending on the MD orientation degree of the filler 120.

The MD orientation degree of the filler 120 dispersed in the optical film 100 may be measured using an FT-IR spectrometer using the following device under the following measurement conditions.

(1) Device and measurement conditions

- FT-IR spectrometer: PerkinElmer spectrum 100
    - Veemax III with ATR and 45-degree ZnSe crystal
    - Incident angle of 80 degrees (air to crystal), polarization angle of 0 degrees

(2) Measurement of absorbance and correction value in MD

To measure a MD absorbance of the filler 120, FT-IR of the optical film 100 in the MD is measured. At this time, light polarized in the TD is irradiated to the optical film 100. Since the Al-O stretching direction of the filler 120 is perpendicular to the length direction of filler 120, light polarized in the TD is irradiated to measure the MD absorbance of filler 120.

The measurement of FT-IR in the MD of the optical film 100 is performed on each of a first surface (S1, belt surface) and a second surface (S2, air surface).

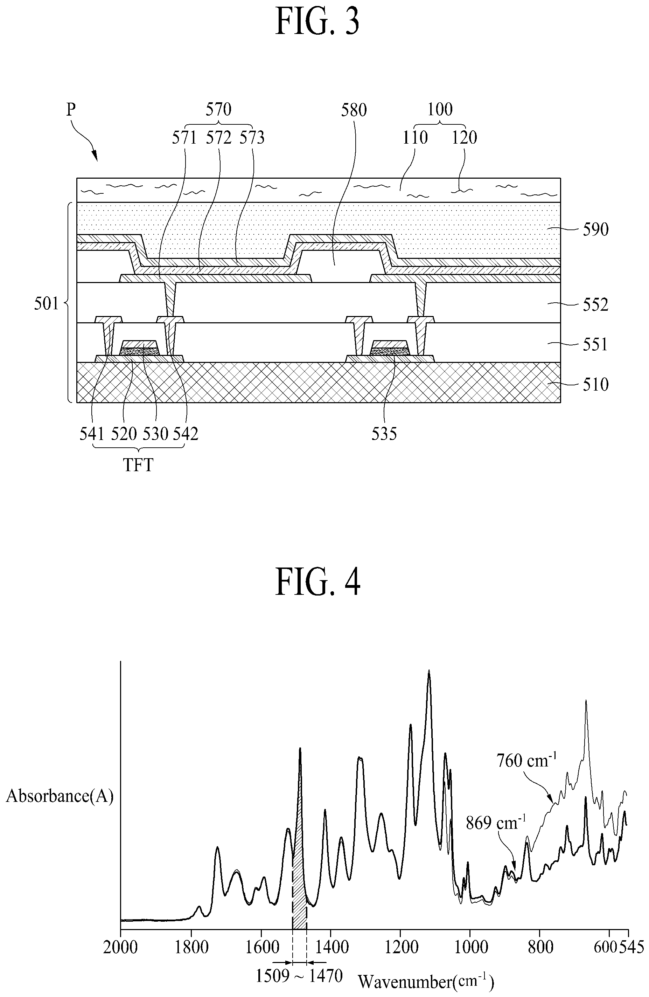

As a result, for example, an FT-IR graph as shown in FIG. 4 may be obtained.

From the result of measurement and graph above, $AlO_{MD}$ and $Ref_{MD}$ may be obtained.

$AlO_{MD}$ is defined as the difference between the absorbance (A) at a wavenumber of 760 $cm^{-1}$ and the absorbance at a wavenumber of 869 $cm^{-1}$, as shown in Equation 1 below.

[Equation 1]

$$AlO_{MD} = A\ (760\ cm^{-1}) - A\ (869\ cm^{-1});\ (MD)$$

$Ref_{MD}$ is defined as an area between wavenumbers 1,509 $cm^{-1}$ and 1,470 $cm^{-1}$ in the FT-IR graph (see FIG. 4). The shaded area between wavenumbers 1,509 $cm^{-1}$ and 1,470 $cm_{-1}$ in FIG. 4 corresponds to $Ref_{MD}$.

In the FT-IR graph of the optical film 100 according to one embodiment of the present disclosure, the area between wavenumbers 1,509 $cm^{-1}$ and 1,470 $cm^{-1}$ is almost constant regardless of the content or presence of the filler. Therefore, in the FT-IR graph, the area between wavenumbers 1,509 $cm^{-1}$ and 1,470 $cm^{-1}$ is referred to as a "dummy area" and the dummy area is used to correct the absorbance.

Next, the absorbance correction value ($A_{MD}$) in the MD is obtained from the $AlO_{MD}$ calculated in Equation 1 and the $Ref_{MD}$ obtained from the FT-IR graph (see FIG. 4). The absorbance correction value in the MD is calculated in accordance with Equation 2 below. According to one embodiment of the present disclosure, the $A_{MD}$ in Equation 2 is referred to as "absorbance correction value in the MD."

[Equation 2]

$$A_{MD} = AlO_{MD}/Ref_{MD}$$

(3) Measurement of absorbance and absorbance correction value in TD

To measure the absorbance of the filler 120 in the TD, FT-IR of the optical film 100 in the TD is measured. At this time, light polarized in the MD is irradiated to the optical film 100. Since the Al-O stretching direction is perpendicular to the longitudinal direction of the filler 120, light polarized in the MD is irradiated to measure the absorbance in the TD.

The measurement of FT-IR of the optical film 100 in the TD is performed on each of the first surface (S1, belt surface) and the second surface (S2, air surface).

As a result, for example, an FT-IR graph as shown in FIG. 4 may be obtained.

From the result of measurement and graph above, $AlO_{TD}$ and $Ref_{TD}$ may be obtained.

$AlO_{TD}$ is defined as the difference between the absorbance (A) at a wavenumber of 760 $cm^{-1}$ and the absorbance at a wavenumber of 869 $cm^{-1}$.

[Equation 3]

$$AlO_{TD} = A(760\ cm^{-1})-A(869\ cm^{-1});\ (TD)$$

$Ref_{TD}$ is defined as the area between wavenumbers 1,509 $cm^{-1}$ and 1,470 $cm^{-1}$ in the FT-IR graph (see FIG. 4). The shaded area between wavenumbers 1,509 $cm^{-1}$ and 1,470 $cm^{-1}$ in FIG. 4 corresponds to $Ref^{TD}$.

Next, the absorbance correction value ($A_{TD}$) in the TD is obtained from the $AlO_{TD}$ calculated in Equation 3 and the $Ref_{TD}$ obtained from the FT-IR graph (see FIG. 4). The absorbance correction value in the TD is calculated in accordance with Equation 4 below. According to one embodiment of the present disclosure, $A_{TD}$ in Equation 4 is referred to as "absorbance correction value in the TD."

[Equation 4]

$$A_{TD} = AlO_{TD}/Ref_{TD}$$

(4) MD orientation degree

From the MD absorbance correction value ($A_{MD}$) calculated in accordance with Equation 2 and the TD absorbance correction value ($A_{TD}$) calculated in accordance with Equation 4, the MD orientation degree of the optical film 100 is calculated in accordance with the following Equation 5.

[Equation 5]

$$\text{MD orientation degree (\%)} = [A_{MD} / (A_{MD} + A_{TD})] \times 100$$

When the MD orientation degree of the filler 120 is less than 60%, the TD tearing strength of the optical film 100 may be insufficient. When the MD orientation degree of the filler 120 is more than 90%, the folding performance of the optical film 100 may be deteriorated.

According to one embodiment of the present disclosure, even when the radius of curvature (R) is 2.0R, excellent TD folding performance may be achieved without causing folding marks. Here, R means 1.0 mm.

Specifically, when the optical film 100 is folded, a mechanical change in the film may occur. In the present

disclosure, the folding mark refers to, for example, a phenomenon in which the film is bent, or the surface of the film is unevenly wrinkled, or clouding occurs in a transparent film. In addition to the wrinkling or clouding, the folding mark may include a length difference before and after folding, or a change in the mechanical and optical properties of the optical film 100, such as a difference in light transmittance.

The optical film 100 according to one embodiment of the present disclosure includes a fiber-shaped filler 120 having a ratio of length to diameter (B/A) in a predetermined range, such that it has an MD orientation degree in the range of 60% to 90% and thus has a high TD tearing strength while preventing a decrease in folding performance, thus exhibiting excellent TD folding performance.

The optical film 100 according to one embodiment of the present disclosure may have a pencil hardness of 2H or more based on a thickness of 50 $\mu$m.

In the present disclosure, the surface hardness of the optical film 100 may be obtained by measuring the pencil hardness of the surface of the optical film 100. Pencil hardness may be measured, for example, by placing the optical film 100 on a glass substrate and measuring pencil hardness on the surface of the optical film 100 disposed on the glass substrate. Specifically, the pencil hardness of the optical film 100 may be measured in accordance with ASTM D 3363 using a pencil hardness meter. The pencil hardness tester may be, for example, a pencil hardness tester from ITOMO.

The optical film 100 according to one embodiment of the present disclosure may have a pencil hardness of 2H or more based on a thickness of 50 $\mu$m, because the fiber-shaped filler 120 links the polymers, especially the chains of the polymers, that constitute the light-transmitting matrix 110.

The optical film 100 according to an embodiment of the present disclosure may have a Vickers hardness (HV) of 41.5 or more based on a thickness of 50 $\mu$m.

The Vickers hardness (HV) of the optical film 100 according to an embodiment of the present disclosure is obtained by pressing the optical film 100 using a diamond pyramid and measuring the surface hardness of the indentations created. The Vickers hardness of the optical film was obtained by calculating HV = C/D wherein C is a pressing load (kg) and D is a surface area ($mm^2$). Vickers hardness was measured using an HM-2000 from Fisher Scientific International, Inc. as a Vickers hardness tester.

When the Vickers hardness of the optical film 100 is less than 41.5, the optical film 100 may be vulnerable to external indentations. For example, when an external force is applied to the outside of the optical film 100, the optical film 100 may be readily scratched or cracked.

According to one embodiment of the present disclosure, the optical film 100 may have a yellowness index of 3 or less based on a thickness of 50 $\mu$m.

According to one embodiment of the present disclosure, although the optical film 100 includes a filler 120 having a diameter-to-length ratio (B/A) of 10 to 500, the filler 120 is uniformly dispersed within the optical film 100 and has a predetermined range of orientation, whereby the yellowness index of the optical film 100 does not increase significantly and thus the optical properties do not deteriorate. More specifically, the optical film 100 may include a filler 120 having a diameter-to-length ratio (B/A) of 100 to 400. Even in this case, the yellowness index of the optical film 100 does not increase significantly and thus the optical properties of the optical film 100 do not deteriorate.

According to one embodiment of the present disclosure, the optical film 100 may have a haze of 4% or less based on a thickness of 50 $\mu$m, and more specifically, may have a haze of 1% or less. Although the length of the filler 120 included in the light-transmitting matrix 110 is relatively great, the diameter of the filler 120 is small and thus an increase in haze due to the filler 120 may be prevented. In particular, by using a fiber-shaped filler 120, adjusting the diameter, length, diameter-to-length ratio (B/A) and content ratio of the filler 120 dispersed in the light-transmitting matrix 110, and improving the dispersibility of the filler 120, a haze of 4% or less, and for example, a haze of 1% or less may be imparted to the optical film 100.

In addition, according to one embodiment of the present disclosure, the optical film 100 may have a light transmittance of 88% or more based on a thickness of 50 $\mu$m. The length of the filler 120 included in the light-transmitting matrix 110 is relatively great, but the diameter of the filler 120 is small. Therefore, a decrease in the light transmittance due to the filler 120 can be prevented. In particular, by using a fiber-shaped filler 120, adjusting the diameter, length, diameter-to-length ratio (B/A) and content ratio of the filler 120 dispersed in the light-transmitting matrix 110, and improving the dispersibility of the filler 120, a light transmittance of 88% or more may be imparted to the optical film 100.

FIG. 2 is a cross-sectional view illustrating a part of a display device 200 according to another embodiment of the present disclosure and FIG. 3 is an enlarged cross-sectional view of "P" in FIG. 2.

Referring to FIG. 2, the display device 200 according to another embodiment of the present disclosure includes a display panel 501 and an optical film 100 on the display panel 501.

Referring to FIGs. 2 and 3, the display panel 501 includes a substrate 510, a thin film transistor TFT on the substrate 510, and an organic light-emitting device 570 connected to the thin film transistor TFT. The organic light-emitting device 570 includes a first electrode 571, an organic light-emitting layer 572 on the first electrode 571, and a second electrode 573 on the organic light-emitting layer 572. The display device 200 shown in FIGs. 4 and 5 is an organic light-emitting display device.

The substrate 510 may be formed of glass or plastic. Specifically, the substrate 510 may be formed of plastic such as a polyimide-based resin or an optical film. Although not shown, a buffer layer may be disposed on the substrate 510.

The thin film transistor TFT is disposed on the substrate 510. The thin film transistor TFT includes a semiconductor layer 520, a gate electrode 530 that is insulated from the semiconductor layer 520 and at least partially overlaps the semiconductor layer 520, a source electrode 541 connected to the semiconductor layer 520, and a drain electrode 542 that is spaced apart from the source electrode 541 and is connected to the semiconductor layer 520.

Referring to FIG. 3, a gate insulating layer 535 is disposed between the gate electrode 530 and the semiconductor layer 520. An interlayer insulating layer 551 may be disposed on the gate electrode 530, and the source electrode 541 and the drain electrode 542 may be disposed on the interlayer insulating layer 551.

A planarization layer 552 is disposed on the thin film transistor TFT to planarize the top of the thin film transistor TFT.

A first electrode 571 is disposed on the planarization layer 552. The first electrode 571 is connected to the thin film transistor TFT through a contact hole provided in the planarization layer 552.

A bank layer 580 is disposed on the planarization layer 552 in a part of the first electrode 571 to define pixel areas or light-emitting areas. For example, the bank layer 580 is disposed in the form of a matrix at the boundaries between a plurality of pixels to define the respective pixel regions.

The organic light-emitting layer 572 is disposed on the first electrode 571. The organic light-emitting layer 572 may also be disposed on the bank layer 580. The organic light-emitting layer 572 may include one light-emitting layer, or two or more light-emitting layers stacked in a vertical direction. Light having any one color among red, green, and blue may be emitted from the organic light-emitting layer 572, and white light may be emitted therefrom.

The second electrode 573 is disposed on the organic light-emitting layer 572.

The first electrode 571, the organic light-emitting layer 572, and the second electrode 573 may be stacked to constitute the organic light-emitting device 570.

Although not shown, when the organic light-emitting layer 572 emits white light, each pixel may include a color filter for filtering the white light emitted from the organic light-emitting layer 572 based on a particular wavelength. The color filter is formed on the light path.

A thin-film encapsulation layer 590 may be disposed on the second electrode 573. The thin-film encapsulation layer 590 may include at least one organic layer and at least one inorganic layer, and the at least one organic layer and the at least one inorganic layer may be alternately disposed.

The optical film 100 is disposed on the display panel 501 having the stack structure described above. The optical film 100 includes a light-transmitting matrix 110 and a filler 120 dispersed in the light-transmitting matrix 110.

Hereinafter, a method of manufacturing an optical film 100 according to another embodiment of the present disclosure will be described.

The method of manufacturing an optical film 100 according to one embodiment of the present disclosure may include primarily dispersing a filler 120 in a resin solution for forming a polymer matrix 110 to prepare a first mixed solution, improving the orientation characteristics of the filler 120 in the first mixed solution, and casting the first mixed solution to prepare a cast film.

According to one embodiment of the present disclosure, a polyimide-based resin solution may be used as the resin solution for forming a polymer matrix 110.

More specifically, the method of manufacturing an optical film 100 according to one embodiment of the present disclosure may include preparing a polyimide-based resin powder, dissolving the polyimide-based resin powder in a first solvent to prepare a polyimide-based resin solution, dispersing the filler 120 in a second solvent to prepare a filler dispersion, and mixing the filler dispersion with the polyimide-based resin solution to prepare a first mixed solution.

DMAc (N,N-dimethylacetamide) may be used as the first solvent. DMAc (N,N-dimethylacetamide) or methyl ethyl ketone (MEK) may be used as the second solvent. However, one embodiment of the present disclosure is not limited thereto and other known solvents may be used as the first solvent and the second solvent.

A fiber-shaped filler 120, for example, a fiber-shaped filler 120 having a large aspect ratio, has a great length relative to its diameter and thus may easily be entangled or agglomerated within the light-transmitting matrix. Therefore, the filler 120 requires excellent dispersibility within the first mixed solution.

According to one embodiment of the present disclosure, to improve the dispersibility of the filler 120, for example, toluene sulfonic acid (p-toluene sulfonic acid, PTSA) may be used as an additive. However, embodiments of the present disclosure are not limited thereto and other known additives may be used to improve the dispersibility of the filler 120.

According to one embodiment of the present disclosure, in order to improve the dispersibility of the filler 120, the pH of the first mixed solution may be adjusted. For example, the pH of the first mixed solution may be adjusted to a range of 5 to 7. Accordingly, the agglomeration or aggregation of the filler 120 may be prevented.

Then, the first mixed solution is cast, dried and heat-treated to form an optical film 100. According to one embodiment of the present disclosure, the film formed by casting the first mixed solution may be referred to as a "cast film" and the film produced by drying and heat-treating the cast film may be referred to as an "optical film 100". The cast film may

be referred to as an "uncured film".

In order to improve the orientation of the filler 120, casting may be performed by bar coating.

According to one embodiment of the present disclosure, the orientation direction and orientation degree of the filler 120 may be changed by controlling the coating pressure applied to the cast film formed by casting. The coating pressure applied to the cast film may be, for example, in the range of 10 to 30 kPa.

In addition, convection may be prevented during drying and heat treatment of the cast film formed by casting, so that the filler 120 may be oriented in a predetermined direction.

Specifically, when convection is generated inside the cast film that is dried using heat, the orientation of the filler 120 may decrease. Thus, the cast film may be allowed to be dried slowly to prevent convection. For example, drying of the cast film may be performed while raising the temperature from 80°C to 120°C at a rate of 1°C/1 min. When drying is performed over a predetermined level, the orientation of the filler 120 may be fixed.

Hereinafter, the present disclosure will be described in more detail with reference to Preparation Examples and Examples. However, the following Preparation examples and Examples should not be construed as limiting the scope of the present disclosure.

<Preparation Example 1: Preparation of polyimide-based polymer solid>

800.50 g of N,N-dimethylacetamide (DMAc) was charged in a 1L reactor equipped with a stirrer, a nitrogen injector, a dropping funnel, a temperature controller, and a cooler while the reactor was purged with nitrogen. Then, the temperature of the reactor was adjusted to 25°C and 29.796 g (0.12 mol) of bis(3-aminophenyl)sulfone) (3DDS) was completely dissolved therein. After complete dissolution of 3DDS, 25.476 g (0.12 mol) of m-tolidine was added thereto and completely dissolved therein, and the resulting solution was maintained at 25°C. 62.459 g (0.12 mol) of 4IBA (4,4'-(4,4'-isopropylidenediphenoxy)bis(phthalic anhydride)) was added thereto and completely dissolved while stirring for 3 hours and then 23.533 g (0.12 mol) of CBDA (cyclobutane-1,2,3,4-tetracarboxylic dianhydride) was added thereto and completely dissolved therein. Polymerization was sufficiently performed at 25°C for 12 hours to obtain a polymer solution having a solid concentration of 15 wt%.

9.49 g of pyridine and 12.25 g of acetic anhydride were added to the obtained polymer solution, and the resulting mixture was stirred for 30 minutes, stirred again at 70°C for 1 hour, and then allowed to cool to room temperature. 20 L of methanol was added to the obtained polymer solution to precipitate a solid, and the precipitated solid was filtered, pulverized, washed again with 2 L of methanol, and dried under vacuum at 100°C for 6 hours to obtain a polyimide-based polymer solid as a powder.

<Preparation Example 2: Preparation of polyimide-based polymer solid>

765.09 g of N,N-dimethylacetamide (DMAc) was charged in a 1L reactor equipped with a stirrer, a nitrogen injector, a dropping funnel, a temperature controller, and a cooler while the reactor was purged with nitrogen. Then, the temperature of the reactor was adjusted to 25°C and 18.16 g (168 mol) of meta-phenylene diamine (mPDA) was completely dissolved therein. 15.28 g (0.072 mol) of m-tolidine was added thereto and completely dissolved therein and the resulting solution was maintained at 25°C. 87.44 g (0.168 mol) of 4,4'-(4,4'-isopropylidenediphenoxy)bis(phthalic anhydride) (4IBA) was added thereto and completely dissolved while stirring for 3 hours. The temperature of the reactor was decreased to 10°C and 14.12 g (0.072 mol) of terephthaloyl chloride (TPC) was added thereto and reacted at 25°C for 12 hours to obtain a polymer solution having a solid concentration of 15 wt%.

9.49 g of pyridine and 12.25 g of acetic anhydride were added to the obtained polymer solution, and the resulting mixture was stirred for 30 minutes, stirred again at 70°C for 1 hour, and then allowed to cool to room temperature. 20 L of methanol was added to the obtained polymer solution to precipitate a solid, and the precipitated solid was filtered, pulverized, washed again with 2 L of methanol, and dried under vacuum at 100°C for 6 hours to obtain a polyimide-based polymer solid as a powder.

<Example 1>

850 g of DMAc (first solvent) was added to a 1 L reactor and the reactor was stirred for a predetermined period of time while the temperature of the reactor was maintained at 10°C. Then, 127 g of the polyimide-based resin powder prepared as the solid powder in Preparation Example 1 was added to the reactor, stirred for 1 hour, and heated to 25°C to prepare a polyimide-based resin solution.

An aluminum oxide hydroxide fiber dispersion was used to add the filler 120. Specifically, an aluminum oxide hydroxide fiber dispersion prepared by dispersing, as the filler 120, an aluminum oxide hydroxide fiber having an average diameter of about 4 nm and an average length of about 1,600 nm at 10 wt% in a DMAc (N,N-dimethylacetamide) solution (second solvent) was used. The content of the filler 120 was 10 wt% based on the total weight of the solid (polyimide-based

resin component + filler).

The aluminum oxide hydroxide fiber dispersion was charged into another 1 L reactor and the prepared liquid polyimide-based resin solution was slowly injected for 1 hour using a cylinder pump, while the temperature of the reactor was maintained at 25°C, to prepare a first mixed solution in which the aluminum oxide hydroxide fiber dispersion was mixed with the polyimide-based resin solution. Here, the filler 120 is an aluminum oxide hydroxide fiber represented by Formula 1.

The pH of the first mixed solution measured immediately after preparation was 8 or higher. In order to improve the arrangement characteristics of the filler 120, a weak acid such as acetic acid was added to the first mixed solution to adjust the pH of the first mixed solution to a range of 5 to 7. The first mixed solution thus prepared was a polyimide-based resin solution in which the fiber-shaped filler 120 is dispersed.

The obtained first mixed solution was cast. A casting substrate was used for casting. At this time, there is no particular limitation on the type of the casting substrate. The casting substrate may be a glass substrate, a stainless steel (SUS) substrate, a Teflon substrate, or the like. According to one embodiment of the present disclosure, a glass substrate was used as the casting substrate.

Specifically, the obtained first mixed solution was applied to a glass substrate and cast. In order to improve the orientation of the filler 120, the first mixed solution was applied to a glass substrate (casting substrate) and then cast while applying a coating pressure of 15 kPa in a direction perpendicular to the glass substrate. As a result, a cast film was produced.

Specifically, the cast film was produced by slowly drying in a hot air oven at 80°C up to 120°C at a rate of 1°C/min for about 40 minutes to maintain the orientation of the filler 120. Then, the produced film was peeled off of the glass substrate and fixed to a frame with pins.

The frame to which the optical film was fixed was slowly heated in a vacuum oven from 100°C to 280°C for 2 hours, cooled slowly and separated from the frame to obtain an optical film. The optical film was heated again at 250°C for 5 minutes.

As a result, an optical film 100 having a thickness of 50 μm and including the light-transmitting matrix 110 and the filler 120 dispersed in the light-transmitting matrix 110 was completed.

<Examples 2 to 5>

The optical films 100 were produced under the conditions of Table 1 in the same manner as in Example 1 and are referred to as "Examples 2 to 5".

<Example 6>

An optical film 100 was manufactured under the conditions of Table 1 in the same manner as in Example 1, except that the polyimide-based resin of the solid powder prepared in Preparation Example 2 was used instead of the polyimide-based resin of the solid powder prepared in Preparation Example 1 and this optical film 100 is referred to as "Example 6".

<Comparative Examples 1 to 5>

Optical films 100 were manufactured under the conditions of Table 1 in the same manner as in Example 1 excluding the coating pressure and are referred to as Comparative Examples 1 to 5.

[Table 1]

| Item | Type of filler | Content of filler (wt%) | Coating pressure (kPa) | Length/ diameter of filler (B/A) |
|---|---|---|---|---|
| Example 1 | Aluminum oxide hydroxide (Formula 1) | 10 | 15 | 400 |
| Example 2 | Aluminum oxide hydroxide (Formula 2) | 10 | 15 | 400 |
| Example 3 | Aluminum oxide hydroxide (Formula 3) | 10 | 15 | 400 |
| Example 4 | Aluminum oxide hydroxide (Formula 1) | 5 | 15 | 400 |
| Example 5 | Aluminum oxide hydroxide (Formula 1) | 20 | 15 | 400 |
| Example 6 | Aluminum oxide hydroxide (Formula 1) | 10 | 15 | 400 |
| Comparative Example 1 | Not added | - | 15 | - |

(continued)

| Item | Type of filler | Content of filler (wt%) | Coating pressure (kPa) | Length/ diameter of filler (B/A) |
|---|---|---|---|---|
| Comparative Example 2 | Silica | 10 | 15 | 1 |
| Comparative Example 3 | Aluminum oxide hydroxide (Formula 1) | 10 | 5 | 400 |
| Comparative Example 4 | Aluminum oxide hydroxide (Formula 1) | 10 | 15 | 600 |
| Comparative Example 5 | Aluminum oxide hydroxide (Formula 1) | 10 | 15 | 5 |
| Alumina oxide hydroxide: aluminum oxide hydroxide fiber dispersion<br>Silica: spherical nano-silica with particle size ranging from 10 to 20 nm | | | | |

<Measurement of physical properties>

The following physical properties of the optical films manufactured in Examples 1 to 6 and Comparative Examples 1 to 5 were measured.

(1) Measurement of tearing strength

The tearing strength (N/mm) of each of optical films manufactured according to Examples 1 to 6 and Comparative Examples 1 to 5 was measured using a universal tensile tester (Model 5967) from Instron in accordance with ASTM D1004 under the following conditions.

- Load Cell 30 kN, Grip 250 N.
- optical film specimen with a size of 100 mm X 100 mm, thickness of 50 μm, tensile speed of 25 mm/min
- the center of the optical film specimen was cut 50 mm in the direction to be measured, both ends of the center of the cut specimen were fixed to a upper load cell and a lower load cell, respectively, tension was applied thereto under the conditions and the tearing strength of the optical film was measured.
- The casting (coating) direction is called "MD", the direction perpendicular to the casting (coating) direction is called "TD", and measurements are performed in both directions

(2) Measurement of modulus

The modulus of each of optical films manufactured according to Examples 1 to 6 and Comparative Examples 1 to 5 was measured using a universal tensile tester (Model 5967) from Instron in accordance with ASTM D885 under the following conditions.

- Load Cell 30 kN, Grip 250 N.
- Sample with a size of 10 mm X 100 mm and thickness of 50 μm, tensile speed of 25 mm/min
- The casting (coating) direction is called "MD", the direction perpendicular to the casting (coating) direction is called "TD", and measurements are performed in both directions

(3) Measurement of surface hardness

1) Measurement of pencil hardness

In order to measure the surface hardness of each of optical films having a thickness of 50 μm manufactured according to Examples 1 to 6 and Comparative Examples 1 to 5, the pencil hardness of the surface of the optical film was measured.

Specifically, each of optical films having a thickness of 50 μm manufactured according to Examples 1 to 6 and Comparative Examples 1 to 5 was placed on a glass substrate, and then the pencil hardness of the optical film was measured using a pencil hardness tester from IMOTO, Japan, in accordance with ASTM D3363 under the conditions of a speed of 180 mm/min and a load of 750 gf.

2) Measurement of Vickers hardness (HV)

The optical films having a thickness of 50 μm manufactured in Examples 1 to 6 and Comparative Examples 1 to 5 were pressed with a diamond pyramid whose opposite faces meet at the apex at an angle of 136 degrees in accordance with ISO 14577-1, and the surface hardness of the indentation formed was measured. The Vickers hardness of the optical film was obtained by calculating HV = C/D wherein C is a pressing load (kg) and D is a surface area ($mm^2$). Vickers hardness was measured using an HM-2000 from Fisher Scientific International, Inc. as a Vickers hardness tester.

- Force: 12 mN
- Running Time: 12 s
- Hold Time: 5 s

(4) Measurement of yellowness index

The yellowness index of each of the optical films with a thickness of 50 μm manufactured according to Examples 1 to 6 and Comparative Examples 1 to 5 was measured using a spectrophotometer (CM-3700D from Konica Minolta) in accordance with ASTM E313.

(5) Measurement of haze

Optical film samples with a size of 50 mm x 50 mm were produced from the optical films having a thickness of 50 μm manufactured in Examples 1 to 6 and Comparative Examples 1 to 5, and the haze of each optical film sample was measured using a haze meter (HM-150, Murakami) in accordance with ASTM D1003.

(6) Measurement of light transmittance (%)

The light transmittance at a wavelength of 360 to 740 nm of each of optical films manufactured in Examples 1 to 6 and Comparative Examples 1 to 5 was measured using a spectrophotometer (CM-3700D, Konica Minolta) in accordance with ASTM E313.

(7) Folding mark

A bending test was performed along the TD as a bending axis on optical film samples with a size of 100 mm X 50 mm, each randomly obtained from optical films having a thickness of 50 μm manufactured according to Examples 1 to 6 and Comparative Examples 1 to 5. The bending test was performed by repeatedly bending the sample having a size of 100 mm X 50 mm 200,000 times at a rate of 60 rpm to a radius of curvature of 2.0 mm (diameter of 4.0 mm) at 25°C/50 RH% using a repeated bending tester (YUASA, DLDM111LHA). Then, whether or not a folding mark was left along one bending axis was determined. When there were any folding marks, such as cracks or clouding, it was marked as "O", and when there were no folding marks, it was marked as "X".

At this time, an analysis method for sharpening the contrast (shading) of the folding indentations may be required. For example, imaging may be performed by inspecting foreign material on the film. If possible, various inspection methods such as reflection, scattering, and transmission methods are used to detect defects or indentations that are difficult to perceive using a CCD camera or the naked eye, in order to detect foreign matter having the same color as the material for the film. Preferred is the use of an inspection (i.e., determination) device rather than a measurement device.

Specifically, for example, the inspection device includes three components, namely, an inspection device, a control unit (controller box: converts laser data received through the inspection device into image data) and a dedicated PC (imaging PC: a PC having installed thereon a dedicated application, which is connected to the control unit (controller box) and is capable of performing image processing). That is, the analysis/evaluation may be performed by setting measurement/evaluation conditions, converting laser data into image data, and conducting analysis using known software for analyzing the brightness, saturation, reflectivity, etc. of the image/photo, but is not limited thereto.

(8) Measurement of orientation degree of filler

1) The MD orientation degree of each of the optical films having a thickness of 50 μm manufactured according to Examples 1 to 6 and Comparative Examples 1 to 5 was measured using an FT-IR spectrometer as follows.
2) Device and measurement conditions

- FT-IR spectrometer: PerkinElmer spectrum 100
- Veemax III with ATR and 45-degree ZnSe crystal
- Incident angle of 80 degrees (air to crystal), polarization angle of 0 degrees

3) Measurement of absorbance and correction value in MD

To measure a MD absorbance of the filler 120, FT-IR of the optical film 100 in the MD was measured. At this time, light polarized in the TD was irradiated to the optical film 100. Since the Al-O stretching direction of the filler 120 is perpendicular to the length direction of filler 120, light polarized in the TD was irradiated to measure the MD absorbance of the filler 120.

The measurement of FT-IR in the MD of the optical film 100 is performed on each of a first surface (S1, belt surface) and a second surface (S2, air surface). As a result, for example, an FT-IR graph as shown in FIG. 4 was obtained.

From the result of measurement and graph above, $AlO_{MD}$ and $Ref_{MD}$ were obtained.

[Equation 1]

$$AlO_{MD} = A\ (760\ cm^{-1}) - A\ (869\ cm^{-1});\ (MD)$$

The absorbance correction value ($A_{MD}$) in the MD was obtained from the $AlO_{MD}$ calculated in Equation 1 and the $Ref_{MD}$ obtained from the FT-IR graph (see FIG. 4). The absorbance correction value in the MD was calculated in accordance with Equation 2 below. The $A_{MD}$ in Equation 2 is referred to as "absorbance correction value in the MD."

[Equation 2]

$$A_{MD} = AlO_{MD}/Ref_{MD}$$

4) Measurement of absorbance and absorbance correction value in TD

To measure the absorbance of the filler 120 in the TD, FT-IR of the optical film 100 in the TD was measured. At this time, light polarized in the MD was irradiated to the optical film 100. Since the Al-O stretching direction is perpendicular to the longitudinal direction of the filler 120, light polarized in the MD was irradiated to measure the absorbance in the TD.

The measurement of FT-IR of the optical film 100 in the TD was performed on each of the first surface (S1, belt surface) and the second surface (S2, air surface). As a result, for example, an FT-IR graph as shown in FIG. 4 was obtained.

From the result of measurement and graph above, $AlO_{TD}$ and $Ref_{TD}$ were obtained.

[Equation 3]

$$AlO_{TD} = A(760\ cm^{-1}) - A(869\ cm^{-1});\ (TD)$$

The absorbance correction value ($A_{TD}$) in the TD was obtained from the $AlO_{TD}$ calculated in Equation 3 and the $Ref_{TD}$ obtained from the FT-IR graph (see FIG. 4). The absorbance correction value in the TD was calculated in accordance with Equation 4 below. $A_{TD}$ in Equation 4 is referred to as "absorbance correction value in the TD."

[Equation 4]

$$A_{TD} = AlO_{TD}/Ref_{TD}$$

5) MD orientation degree

From the MD absorbance correction value ($A_{MD}$) calculated in accordance with Equation 2 and the TD absorbance correction value ($A_{TD}$) calculated in accordance with Equation 4, the MD orientation degree of the optical film 100 was calculated in accordance with the following Equation 5.

[Equation 5]

$$\text{MD orientation degree (\%)} = [A_{MD} / (A_{MD} + A_{TD})] \times 100$$

The results of measurement are shown in Tables 2 and 3 below.

[Table 2]

| Item | Modulus (GPa) | | | Folding performance (folding mark) | Orientation degree (%, MD) | | |
|---|---|---|---|---|---|---|---|
| | MD | TD | Average | | Air surface | Belt surface | Average |
| Example 1 | 9.2 | 6.8 | 8.3 | X | 83 | 79 | 81 |
| Example 2 | 9.4 | 7 | 8.2 | X | 84 | 78 | 81 |
| Example 3 | 9.0 | 6.9 | 8.0 | X | 86 | 79 | 82 |
| Example 4 | 7.9 | 7 | 7.5 | X | 74 | 70 | 72 |
| Example 5 | 11.6 | 8 | 9.8 | X | 85 | 83 | 84 |
| Example 6 | 10 | 7.4 | 8.7 | X | 88 | 80 | 84 |
| Comparative Example 1 | 4.8 | 4.7 | 4.8 | X | - | - | - |
| Comparative Example 2 | 5.6 | 5.9 | 5.8 | X | - | - | - |
| Comparative Example 3 | 7.6 | 7.5 | 7.6 | X | 55 | 52 | 53 |
| Comparative Example 4 | 9.1 | 6.9 | 8.0 | O | 93 | 90 | 91 |
| Comparative Example 5 | 7.6 | 7.1 | 7.4 | X | 60 | 56 | 58 |

[Table 3]

| Item | Tearing strength (N/mm) | | | Teari ng index | Penc il hard ness | Vickers hardnes s | Yello wness index (Y.I. ) | Haze (%) | Light transmi ttance (%) |
|---|---|---|---|---|---|---|---|---|---|
| | MD | TD | Aver age | | | | | | |
| Example 1 | 2.63 | 3.45 | 3.04 | 1.31 | 2H | 44.8 | 2.95 | 0.2 | 88.6 |
| Example 2 | 2.61 | 3.45 | 3.03 | 1.32 | 2H | 45 | 2.98 | 0.2 | 88.7 |
| Example 3 | 2.65 | 3.49 | 3.07 | 1.32 | 2H | 44.9 | 2.92 | 0.2 | 88.7 |
| Example 4 | 2.17 | 2.40 | 2.29 | 1.11 | 2H | 41.9 | 2. 97 | 0.2 | 88.2 |
| Example 5 | 3.53 | 4.98 | 4.26 | 1.41 | 3H | 45 | 2.94 | 0.2 | 88.5 |
| Example 6 | 2.64 | 3.43 | 3.04 | 1.30 | 3H | 45.5 | 2.97 | 0.2 | 88.4 |
| Comparative Example 1 | 1.64 | 1.69 | 1.67 | 1.03 | H | 41.3 | 3.00 | 0.2 | 88.5 |
| Comparative Example 2 | 1.72 | 1.75 | 1.74 | 1.02 | H | 41.1 | 2.98 | 0.2 | 88.2 |
| Comparative Example 3 | 2.71 | 2.80 | 2.76 | 1.03 | 2H | 44.2 | 3.45 | 0.9 | 88.0 |
| Comparative Example 4 | 2.66 | 3.43 | 3.05 | 1.29 | 2H | 44.4 | 2.95 | 0.2 | 88.6 |
| Comparative Example 5 | 1.80 | 1.87 | 1.84 | 1.04 | 2H | 44.4 | 3.05 | 0.3 | 88.4 |
| Tearing Index: TD tearing strength / MD tearing strength | | | | | | | | | |

As can be seen from the results of measurement in Tables 2 and 3, the optical films according to Examples 1 to 6 of the present disclosure have excellent mechanical properties, such as a tearing strength of 2.20 N/mm or more and a modulus of 7 GPa or more, and a tearing index of 1.10 to 1.50. In addition, it can be seen that the optical properties, such as light transmittance, yellowness, and haze, are not reduced although the optical films include a fiber-shaped filler.

On the other hand, it can be seen that the optical films according to Comparative Examples 1 and 2 have low tearing strength and low modulus, and do not satisfy a tearing index of 1.10 to 1.50. It can be seen that the optical film

according to Comparative Example 3 has a yellowness index of 3 or more and an MD orientation degree of less than 60%, and does not satisfy a tearing index in the range of 1.10 to 1.50. The optical film according to Comparative Example 4 has excellent tearing strength and tearing index, but has an MD orientation degree of more than 90%, and leaves folding marks when folding performance is measured. It can be seen that the optical film according to Comparative Example 5 has low tearing strength and does not satisfy a tearing index in the range of 1.10 to 1.50.

[Explanation of reference numerals]

100: Optical film
110: Light-transmitting matrix
120: Filler
200: Display device
501: Display panel

**Claims**

**1.** An optical film comprising:

a light-transmitting matrix; and
a filler dispersed in the light-transmitting matrix,
wherein the filler has a fiber shape,
the filler has B/A of 10 to 500, wherein the A represents a diameter of the filler and the B represents a length of the filler, and
the optical film has a tearing index of 1.10 to 1.50,
wherein the tearing index is calculated in accordance with the following Equation 1:

Tearing Index = TD tearing strength / MD tearing strength [Equation 1]

wherein the machine direction (MD) is a direction parallel to a casting direction of the optical film during a manufacturing process of the optical film and the transverse direction (TD) is a direction perpendicular to the machine direction (MD).

**2.** The optical film according to claim 1, wherein the optical film has B/A of 200 to 400.

**3.** The optical film according to claim 1, wherein the filler has a diameter of 2 nm to 10 nm and a length of 200 nm to 4,000 nm.

**4.** The optical film according to claim 1, wherein the filler comprises at least one of glass fiber, an aluminum-based fiber, or fluoride fiber.

**5.** The optical film according to claim 1, wherein the filler comprises aluminum oxide hydroxide.

**6.** The optical film according to claim 1, wherein a content of the filler is 1 to 40 wt% based on a total weight of the optical film.

**7.** The optical film according to claim 1, wherein the optical film has a TD tearing strength of 2.0 N/mm or more.

**8.** The optical film according to claim 1, wherein the optical film has a modulus of 7 GPa or more based on a thickness of 50 μm.

**9.** The optical film according to claim 1, wherein the filler has a MD orientation degree of 60% to 90%,

wherein the MD is a casting direction of the optical film during a manufacturing process of the optical film, and the MD orientation degree is measured under the following conditions using a FT-IR spectrometer,

- FT-IR spectrometer: PerkinElmer spectrum 100
- Veemax III with ATR and 45-degree ZnSe crystal
- Incident angle of 80 degrees (air to crystal), polarization angle of 0 degrees

**10.** The optical film according to claim 1, wherein the optical film has a surface hardness of 2H or higher based on a thickness of 50 μm.

**11.** The optical film according to claim 1, wherein the optical film has a yellowness index of 3 or less based on a thickness of 50 μm.

**12.** A display device comprising:

a display panel; and
the optical film according to any one of claims 1 to 11 disposed on the display panel.

**13.** A method of manufacturing an optical film comprising:

primarily dispersing a filler in a resin solution for forming a polymer matrix to prepare a first mixed solution;
adjusting a pH of the first mixed solution to a range of 5 to 7 to improve arrangement characteristics of the filler in the first mixed solution;
casting the first mixed solution to prepare a cast film;
applying a coating pressure of 10 to 30 kPa to the cast film; and
drying the cast film while heating at a heating rate of 1°C/1 minute from 80°C to 120°C,
wherein the filler has a fiber shape, and
the filler has B/A of 10 to 500, wherein the A represents a diameter of the filler and the B represents a length of the filler.

# FIG. 1

100
110
120
S2
S1

# FIG. 2

200
P
100
501

FIG. 3

P
570
571 572 573
580
100
110 120
590
501
552
551
510
541 520 530 542
TFT
535

FIG. 4

Absorbance(A)
760 cm-1
869 cm-1
2000
1800
1600
1400
1200
1000
800
600
545
1509 ~ 1470
Wavenumber(cm-1)

**INTERNATIONAL SEARCH REPORT**

International application No. **PCT/KR2024/018466**

**A. CLASSIFICATION OF SUBJECT MATTER**

**H10K 59/80**(2023.01)i; **B29C 39/14**(2006.01)i; **B29C 39/38**(2006.01)i; **B29C 39/00**(2006.01)i; **B29C 70/06**(2006.01)i; **C08J 5/18**(2006.01)i; **C08K 5/12**(2006.01)i; **C08K 7/02**(2006.01)i; **C08K 3/22**(2006.01)i

According to International Patent Classification (IPC) or to both national classification and IPC

**B. FIELDS SEARCHED**

Minimum documentation searched (classification system followed by classification symbols)

H10K 59/80(2023.01); B29C 61/06(2006.01); B32B 27/28(2006.01); C08J 5/18(2006.01); C08K 3/36(2006.01); C08K 7/08(2006.01); C08L 101/00(2006.01); C08L 67/00(2006.01); C09D 17/00(2006.01); F21V 7/00(2006.01); G02B 5/02(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 광학 필름(optical film), 매트릭스(matrix), 필러(filler), 섬유 형상(fiber shape), 인열 지수(tearing index), 인열 강도(tear strength), TD 방향(transverse direction), MD 방향(machine direction)

**C. DOCUMENTS CONSIDERED TO BE RELEVANT**

| Category* | Citation of document, with indication, where appropriate, of the relevant passages | Relevant to claim No. |
|---|---|---|
| Y | KR 10-2023-0004443 A (TAIYO HOLDINGS CO., LTD.) 06 January 2023 (2023-01-06) See paragraphs [0083], [0086]-[0087], [0089], [0101], [0109] and [0121]-[0122]; and claims 1, 3-4 and 6. | 1-13 |
| Y | JP 2006-045317 A (MITSUBISHI PLASTICS, INC.) 16 February 2006 (2006-02-16) See paragraph [0044]. | 1-12 |
| Y | JP 2007-231213 A (TORAY INDUSTRIES, INC.) 13 September 2007 (2007-09-13) See abstract; and claims 1 and 3. | 13 |
| A | KR 10-2014-0076892 A (GL KOREA CO., LTD.) 23 June 2014 (2014-06-23) See paragraphs [0018]-[0020]; and figure 1. | 1-13 |
| A | KR 10-2022-0007548 A (KOLON INDUSTRIES, INC.) 18 January 2022 (2022-01-18) See paragraphs [0201]-[0202] and [0208]; and claims 1 and 6-10. | 1-13 |

☐ Further documents are listed in the continuation of Box C. ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **04 March 2025** | **04 March 2025** |

| Name and mailing address of the ISA/KR | Authorized officer |
|---|---|
| **Korean Intellectual Property Office Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**
**Information on patent family members**

International application No.
**PCT/KR2024/018466**

| Patent document cited in search report | Publication date (day/month/year) | Patent family member(s) | Publication date (day/month/year) |
|---|---|---|---|
| KR 10-2023-0004443 A | 06 January 2023 | CN 115461411 A | 09 December 2022 |
| | | TW 202206547 A | 16 February 2022 |
| | | WO 2021-221118 A1 | 04 November 2021 |
| JP 2006-045317 A | 16 February 2006 | JP 4634092 B2 | 16 February 2011 |
| JP 2007-231213 A | 13 September 2007 | JP 5151042 B2 | 27 February 2013 |
| KR 10-2014-0076892 A | 23 June 2014 | None | |
| KR 10-2022-0007548 A | 18 January 2022 | CN 115803385 A | 14 March 2023 |
| | | CN 115803385 B | 15 October 2024 |
| | | JP 2023-533275 A | 02 August 2023 |
| | | JP 7617241 B2 | 17 January 2025 |
| | | KR 10-2688950 B1 | 26 July 2024 |
| | | TW 202204504 A | 01 February 2022 |
| | | TW I795837 B | 11 March 2023 |
| | | US 2023-0257532 A1 | 17 August 2023 |
| | | WO 2022-010298 A1 | 13 January 2022 |

Form PCT/ISA/210 (patent family annex) (July 2022)